# EUROPÄISCHE PATENTSCHRIFT

(11) **EP 1 647 703 B1**
(45) Veröffentlichungstag und Bekanntmachung des Hinweises auf die Patenterteilung: **27.02.2008**
(21) Anmeldenummer: 05109417.5
(22) Anmeldetag: 11.10.2005
(51) Int. Cl.: F02M 51/06, F02M 59/46, H01L 41/053

(54) **Aktormodul**
Actuator module
Module actionneur

(30) Priorität: 15.10.2004 DE 102004050224
(43) Veröffentlichungstag der Anmeldung: 19.04.2006
(73) Patentinhaber: ROBERT BOSCH GMBH, 70442 Stuttgart (DE)
(72) Erfinder: Liskow, Uwe, 71679 Asperg (DE); Huebel, Michael, 70839 Gerlingen (DE)

(56) Entgegenhaltungen:
- WO-A-02/40858
- DE-A1- 10 040 239
- DE-A1- 19 818 068
- DE-A1- 19 946 965
- DE-A1- 19 947 067
- DE-A1- 19 947 779
- DE-A1-3102004 002 13

## Beschreibung

### Stand der Technik

Die Erfindung geht aus von einem Aktormodul nach der Gattung des Hauptanspruchs. Es ist schon ein Brennstoffeinspritzventil aus der WO 02/40858 bekannt, mit einem piezoelektrischen Aktor und einer den Aktor umgebenden Aktorhülse, die von der einen Stirnseite von einem Aktorkopf und von der anderen Stirnseite von einem Aktorfuß verschlossen ist, und mit zumindest einem Dämpfungselement zur Dämpfung der vom Aktor ausgehenden Schallwellen. Nachteilig ist, dass das Dämpfungselement außerhalb der Aktorhülse vorgesehen ist, da die Dämpfung zu weit entfernt von der Schallquelle erfolgt und erst stattfindet, nachdem der Schall bereits in das Ventilgehäuse übergegangen ist. Dadurch wird nur ein Teil der vom Aktor ausgehenden Schallwellen gedämpft, so dass die Schalldämpfung nicht ausreichend ausgeführt ist.

Aus der DE 198 18 068 A1 ist ein Aktormodul mit einem piezoelektrischen Aktor und einer den Aktor umgebenden Hülse bekannt, die stirnseitig von einem Aktorkopf und einem Aktorfuß verschlossen ist. Die Hohlräume zwischen der Aktorhülse 4 und dem Aktor 3 sind mit einer elastischen Masse 55 ausgefüllt, die u.a. dämpfend wirkt.

Aus der DE 100 40 239 A1 ist ein Aktormodul bekannt, in dessen Aktorkopf eine die Schallausbreitung behindernde Zwischenschicht integriert ist.

Die WO 02/40858 A1, die DE 199 47 779 A1 und die DE 199 46 965 A1 offenbaren jeweils ein Aktormodul mit einem außerhalb der Aktorhülse vorgesehenen Dämpfungselement.

### Vorteile der Erfindung

Das erfindungsgemäße Aktormodul mit den kennzeichnenden Merkmalen des Hauptanspruchs hat demgegenüber den Vorteil, daß auf einfache Art und Weise eine Verbesserung der Schalldämpfung erzielt wird, indem das zumindest eine Dämpfungselement in der Aktorhülse angeordnet ist.

Durch die in den Unteransprüchen aufgeführten Maßnahmen sind vorteilhafte Weiterbildungen und Verbesserungen des im Hauptanspruch angegebenen Aktormoduls möglich.

Gemäß einer vorteilhaften Ausgestaltung ist das Dämpfungselement zwischen dem Aktorkopf und dem Aktor und/oder zwischen dem Aktorfuß und dem Aktor angeordnet.

Besonders vorteilhaft ist, wenn das Dämpfungselement aus Faserwerkstoff hergestellt ist, da der Faserwerkstoff sehr kostengünstig ist und eine derart hohe Festigkeit aufweist, dass keine den Hub verringernden Setzerscheinungen während der Lebensdauer des Aktormoduls auftreten. Nach einer vorteilhaften Ausführung ist vorgesehen, als Faserwerkstoff Aramidfaser, Kohlefaser oder Glasfaser zu verwenden.

Sehr vorteilhaft ist es, wenn das zumindest eine Dämpfungselement scheibenförmig oder lochscheibenförmig ausgebildet ist, da diese Formen besonders einfach herstellbar sind.

Auch vorteilhaft ist, wenn in der Aktorhülse eine zusätzliche Aktorplatte vorgesehen ist, die mit einem Zapfen in eine an dem Aktorkopf oder dem Aktorfuß ausgebildete Vertiefung hineinragt, wobei das Dämpfungselement in einem Spalt zwischen dem Zapfen und einer Wandung der Vertiefung angeordnet ist. Auf diese Weise wird erreicht, dass sich das Dämpfungselement beim Hub des Aktors steif verhält und zumindest nahezu keinen Hubverlust zuläßt, aber nach dem Hub des Aktors eine schalldämpfende Wirkung aufweist.

Desweiteren vorteilhaft ist, wenn das Dämpfungselement topfförmig mit einem Axialabschnitt und einem Topfboden ausgebildet ist. Vorteilhafterweise kann das Dämpfungselement auch hülsenförmig mit einem Axialabschnitt und einer zweiten Schulter ausgeführt sein. Der Topfboden und die zweite Schulter übertragen den Hub jeweils hubverlustfrei und der Axialabschnitt erreicht nach dem Hub eine Schallabsorption.

Darüber hinaus vorteilhaft ist, wenn das Dämpfungselement eine elastische Dämpfungsschicht aufweist, die beispielsweise aus einem Elastomer oder aus Gummi hergestellt ist. Die Schwingungsenergie des Körperschalls wird in der elastischen Dämpfungsschicht durch innere Reibung in Wärme umgewandelt, so dass die mechanische Energie des Körperschalls stark verringert und eine sehr gute Schalldämpfung erzielt wird.

Außerdem vorteilhaft ist, wenn die elastische Dämpfungsschicht zwischen zwei Deckschichten des Dämpfungselements, die beispielsweise aus Stahlblech gebildet sind, angeordnet ist, da die elastische Dämpfungsschicht auf diese Weise weniger leicht beschädigbar und weniger versprödungsanfällig ist.

### Zeichnung

Es zeigen Fig.1 ein schematisch dargestelltes Brennstoffeinspritzventil, Fig.2 ein erfindungsgemäßes Aktormodul gemäß einem ersten Ausführungsbeispiel, Fig.3 ein Aktormodul gemäß einem zweiten, Fig. 4 ein weiteres Aktormodul gemäß einem dritten und Fig.5 ein Aktormodul gemäß einem vierten Ausführungsbeispiel.

### Beschreibung der Ausführungsbeispiele

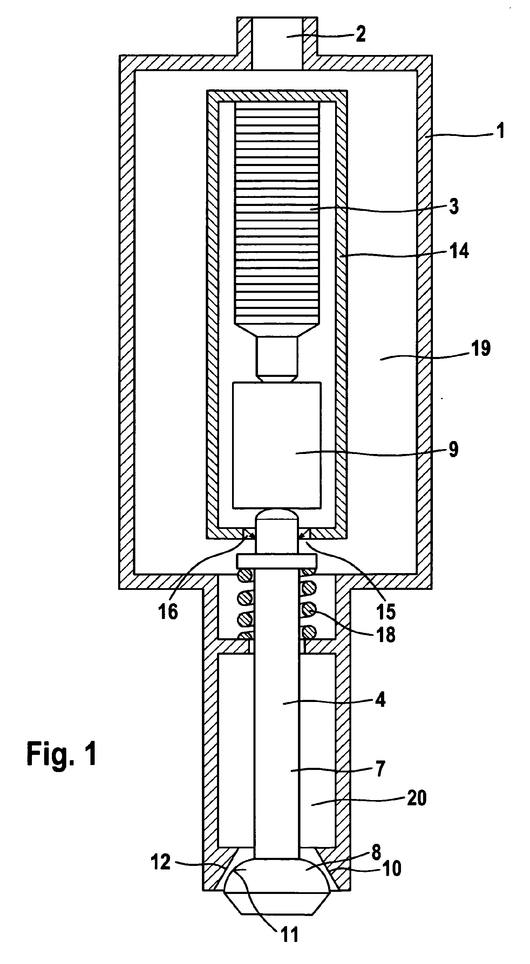

Fig.1 zeigt ein Brennstoffeinspritzventil, bei dem beispielsweise ein erfindungsgemäß ausgebildetes Aktormodul Verwendung findet.

Das Aktormodul kann aber ausdrücklich auch in anderen Stellgliedern, beispielsweise in beliebigen Ventilen, eingesetzt werden.

Das Brennstoffeinspritzventil dient dazu, Kraftstoff in einen Brennraum einer Brennkraftmaschine einzuspritzen und wird beispielsweise bei der sogenannten Direkteinspritzung verwendet.

Das Brennstoffeinspritzventil hat ein Ventilgehäuse 1 mit einem Eingangskanal 2 für den Kraftstoff. In dem Ventilgehäuse 1 ist ein schematisch dargestelltes Aktormodul 3 zur axialen Verstellung einer Ventilnadel 4 angeordnet.

Die Ventilnadel 4 ist in dem Ventilgehäuse 1 axial beweglich vorgesehen und weist beispielsweise einen dem Aktormodul 3 zugewandten Nadelschaft 7 und einen dem Aktormodul 3 abgewandten Ventilschließkörper 8 auf. Das Aktormodul 3 überträgt seine Bewegung beispielsweise über einen sogenannten hydraulischen Koppler 9 auf den Nadelschaft 7 der Ventilnadel 4, wodurch der mit einem Ventilsitz 10 zusammenwirkende Ventilschließkörper 8 das Brennstoffeinspritzventil öffnet oder schließt. Das Brennstoffeinspritzventil weist beispielsweise einen sogenannten Kugel-Kegelsitz auf, wobei der Ventilsitz 10 beispielsweise kegelförmig ausgebildet ist und der Ventilschließkörper 8 einen mit dem Ventilsitz 10 zusammenwirkenden Kugel- oder Radienabschnitt 11 aufweist. Bei geschlossenem Brennstoffeinspritzvenlil liegt der Ventilschließkörper 8 über seinen gesamten Umfang an dem Ventilsitz 10 mit Linien- oder Flächenberührung dicht an und bildet einen Dichtsitz 12.

Das Aktormodul 3 weist einen piezoelektrischen oder magnetostriktiven oder einen Formgedächtnis-Aktor 3.1 auf und ist beispielsweise in einem Aktorgehäuse 14 angeordnet, um diesen beispielsweise gegenüber dem Kraftstoff zu kapseln. Das Aktorgehäuse 14 ist im Ventilgehäuse 1 angeordnet und beispielsweise zylindrisch ausgeführt. In dem Aktorgehäuse 14 ist neben dem Aktor 3 beispielsweise auch der hydraulische Koppler 9 vorgesehen. Der Nadelschaft 7 der Ventilnadel 4 verläuft im Aktorgehäuse 14 von dem hydraulischen Koppler 9 ausgehend in Richtung Ventilsitz 10 und durchragt das Aktorgehäuse 14 durch eine Durchgangsöffnung 15 bis nach außerhalb des Aktorgehäuses 14. Die Durchgangsöffnung 15 des Aktorgehäuses 14 ist mittels einer Dichtung 16, beispielsweise mittels eines Wellbalgs, der an seinem einem Ende mit dem Aktorgehäuse 14 und an seinem anderen Ende mit dem Nadelschaft 7 verbunden ist, gegenüber dem Kraftstoff abgedichtet, so daß kein Kraftstoff aus dem Ventilgehäuse 1 in das Aktorgehäuse 14 gelangen kann.

Ein piezoelektrischer Aktor 3.1 besteht aus einer Vielzahl von piezokeramischen Schichten, die durch Anlegen einer elektrischen Spannung eine Dehnung in axialer Richtung ausführen. Dabei wird der sogenannte inverse piezoelektrische Effekt ausgenutzt, bei dem elektrische Energie in mechanische Energie umgewandelt wird. Die durch das Anlegen der elektrischen Spannung erzeugte Dehnung der piezokeramischen Schichten wird über den hydraulischen Koppler 9 auf die Ventilnadel 4 übertragen, wobei die Ventilnadel 4 beispielsweise einen Hub von 40 bis 50 Mikrometer ausführt. Nach erfolgter Öffnung des Brennstoffeinspritzventils verkürzt sich der Aktor 3 nach Abschalten der elektrischen Spannung und die Ventilnadel 4 wird mittels einer Feder 18 wieder in Richtung Ventilsitz 10 zurückbewegt und schließt das Brennstoffeinspritzventil.

Da sich der Aktor 3.1 und die übrigen Komponenten des Brennstoffeinspritzventils, beispielsweise das Ventilgehäuse 1, wegen unterschiedlicher thermischer Ausdehnungskoeffizienten bei Temperaturänderung unterschiedlich stark ausdehnen, muß der hydraulische Koppler 9 die Differenzen in der unterschiedlichen Längenausdehnung ausgleichen, um zu gewährleisten, daß das Brennstoffeinspritzventil mit der Ventilnadel 4 unabhängig von der jeweiligen Temperatur des Brennstoffeinspritzventils bei einer Öffnungsbewegung jeweils zumindest annähernd den gleichen Hub ausführt wie der Aktor 3.1.

Der Kraftstoff wird im Ventilgehäuse 1 ausgehend vom Eingangskanal 2 über einen ersten Ringspalt 19 zwischen dem Ventilgehäuse 1 und dem Aktorgehäuse 14 und über einen zweiten Ringspalt 20 zwischen dem Ventilgehäuse 1 und der Ventilnadel 4 bis an den Ventilschließkörper 8 stromauf des Dichtsitzes 12 geleitet. Beim Öffnen des Brennstoffeinspritzventils hebt der Ventilschließkörper 8 von dem Ventilsitz 10 ab, wodurch eine Verbindung zu dem Brennraum der Brennkraftmaschine geöffnet wird, so daß Kraftstoff über einen zwischen dem Ventilschließkörper 8 und dem Ventilsitz 10 gebildeten Ausgangsspalt in den Brennraum ausströmt. Der Ausgangsspalt erweitert sich beispielsweise in Strömungsrichtung und wirkt dadurch als Diffusor. Je größer der Hub der Ventilnadel 4 in Öffnungsrichtung ist, desto größer ist der Ausgangsspalt und desto mehr Kraftstoff wird pro Zeiteinheit in den Brennraum eingespritzt.

Der Aktor 3.1 wird von einem Steuergerät 23 in Abhängigkeit von Betriebsparametern mit hoher Frequenz getaktet ein- oder ausgeschaltet, wobei durch sogenannte Störkapazitäten gegen Masse ungewollt Störströme und Störspannungen erzeugt werden. Die durch die Störkapazitäten hervorgerufenen elektromagnetischen Störungen führen zur Störung von elektrischen Vorrichtungen, beispielsweise des Radioempfangs, und müssen deshalb durch geeignete Maßnahmen verringert werden.

Ein Aktormodul mit verringerten elektromagnetischen Störungen ist beispielsweise in der nachveröffentlichten deutschen Patentanmeldung 10 2004 0021 33 A1 vorgeschlagen, wobei deren Inhalt ausdrücklich Teil der Offenbarung dieser Anmeldung sein soll.

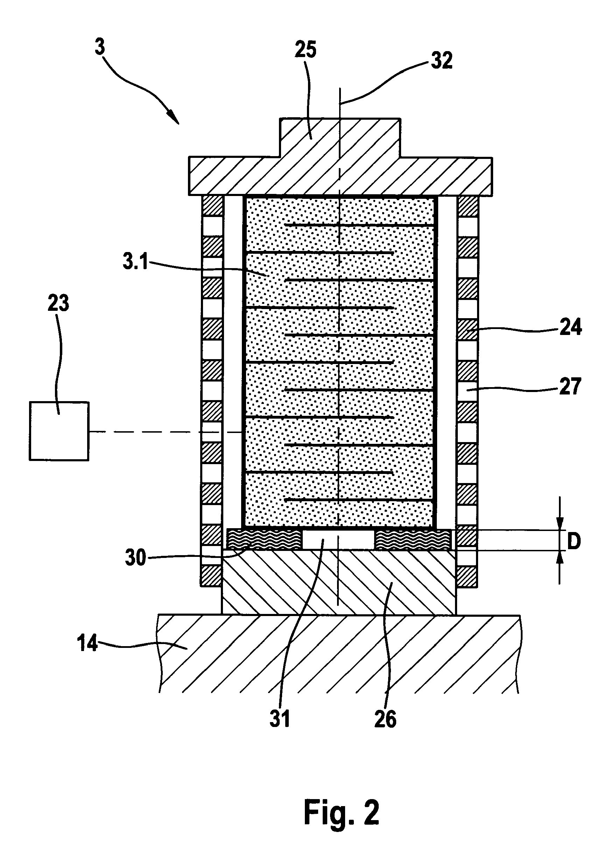

Fig.2 zeigt ein erfindungsgemäßes Aktormodul gemäß einem ersten Ausführungsbeispiel.

Bei dem Aktormodul nach Fig.2 sind die gegenüber dem Brennstoffeinspritzventil nach Fig. gleichbleibenden oder gleichwirkenden Teile durch die gleichen Bezugszeichen gekennzeichnet.

Das Aktomodul 3 macht beim Anlegen eines elektrischen Signals an den Aktor 3.1 einen Hub und betätigt auf diese Weise ein beliebiges Stellglied, beispielsweise die Ventilnadel 4 eines Brennstoffeinspritzventils.

Der Aktor 3.1 ist von einer Aktorhülse 24 ringförmig umgeben, die beispielsweise auf einer der Ventilnadel 4 zugewandten Stirnseite von einem Aktorkopf 25 und beispielsweise auf der der Ventilnadel 4 abgewandten Stirnseite von einem Aktorfuß 26 verschlossen ist. Beispielsweise sind der Aktorkopf 25 und der Aktorfuß 26 jeweils mit der Aktorhülse 24 verschweisst.

Die Aktorhülse 24 ist beispielsweise als sogenannte Rohrfeder ausgebildet, deren Elastizität durch in der Aktorhülse 24 ausgebildete Ausnehmungen 27 vergrößert ist. Beispielsweise sind die Ausnehmungen 27 knochenförmig, kreisförmig, langlochförmig oder ähnlich ausgeführt. Die Aktorhülse 24, der Aktorkopf 25 und der Aktorfuß 26 sind beispielsweise aus Stahl hergestellt.

Eine Rohrfeder ist beispielsweise in der nachveröffentlichten deutschen Patentanmeldung 10 2004 02 26 19 vorgeschlagen, wobei deren Inhalt ausdrücklich Teil der Offenbarung dieser Anmeldung sein soll.

Der Aktor 3.1 ist in der Aktorhülse 24 zwischen dem Aktorkopf 25 und dem Aktorfuß 26 eingespannt und wird auf Druck belastet. Auf diese Weise wird der Aktor 3.1 vor schädlichen Zugspannungen geschützt.

Der Aktor 3.1 wird in sehr hoher Frequenz elektrisch erregt, so dass von dem Aktor 3.1 Schallwellen erzeugt werden, die über die den Aktor 3.1 angrenzende Umgebung abgestrahlt wird. Schallwellen breiten sich allgemein sowohl über feste, flüssige als auch gasförmige Materie aus. Der sich in festen Körpern ausbreitende oder weitergeleitete Schall wird als Körperschall bezeichnet. Beispielsweise werden die Schallwellen des Körperschalls über das Aktorgehäuse 14 und das Ventilgehäuse 1 des Brennstoffeinspritzventils bis auf die Brennkraftmaschine übertragen, in der das Brennstoffeinspritzventil eingebaut ist. Damit die von einem Fahrer eines Fahrzeugs wahrnehmbaren Geräusche der Brennstoffeinspritzventile keinen unzulässigen Wert überschreiten, muss die Schalleistung gedämpft werden. Daher ist zumindest ein Dämpfungselement 30 vorgesehen, das den Körperschall bei der Weiterleitung vom Aktor 3.1 auf das Aktorgehäuse 14 und das Ventilgehäuse 1 dämpft.

Die Schalldämpfung muss möglichst sehr nah an dem die Schallquelle bildenden Aktor 3.1 erfolgen, um die Schallausbreitung wirksam zu verringern. Erfindungsgemäß ist deshalb vorgesehen, das zumindest eine Dämpfungselement 30 in der Aktorhülse 24 anzuordnen. Es ist aber auch möglich, das Dämpfungselement 30 ausserhalb der Aktorhülse 24 anzuordnen, mit dem Nachteil, dass die Schalldämpfung weiter entfernt von der Schallquelle erfolgt und daher geringer ist als bei der Anordnung des Dämpfungselements 30 in der Aktorhülse 24.

Beispielsweise ist das zumindest eine Dämpfungselement 30 zwischen dem Aktorkopf 25 und dem Aktor 3.1 und/oder zwischen dem Aktorfuß 26 und dem Aktor 3.1 plaziert. In Fig.2 ist das Dämpfungselement 30 beispielsweise auf der dem Aktorfuß 26 zugewandten Stirnseite des Aktors 3.1 vorgesehen, um die Körperschallübertragung auf das Aktorgehäuse 14 effektiv zu dämpfen.

Das zumindest eine Dämpfungselement 30 ist gemäß einem ersten Ausführungsbeispiel aus einem halbsynthetischen oder synthetischen Faser- bzw. Tuchwerkstoff hergestellt, zum Beispiel aus Aramidfaser, Kohlefaser, Glasfaser, oder ähnlichen Kunstfasern. Aramidfasern bestehen beispielsweise aus Polyamiden. Das Fasermaterial weist eine hohe Festigkeit auf, so dass sich keine Verringerung einer axialen Dicke D bezüglich einer Aktorachse 32 über die Lebensdauer des Brennstoffeinspritzventils einstellt. Dies würde zu einem unzulässigen betriebszeitabhängigen Hubverlust des Aktors 3.1 führen. Beim Stand der Technik ist das Dämpfungselement 30 außerhalb der Aktorhülse 24 angeordnet, da bisher kein geeignetes Dämpfungselement 30 bekannt war, das keinen oder nur einen sehr geringen Hubverlust pro Schaltvorgang erzeugt und keine Verringerung der axialen Dicke D über die Lebenszeit des Stellglieds aufweist.

Beispielsweise ist das zumindest eine Dämpfungselement 30 scheibenförmig, lochscheibenförmig, plattenförmig oder ähnlich ausgebildet. Die Scheibenform oder Plattenform des Dämpfungselementes 30 ist beliebig, beispielsweise kreisförmig, rechteckig, quadratisch, vieleckig oder ähnlich. Das Dämpfungselement 30 hat ähnlich einer Lochscheibe beispielsweise eine Ausnehmung 31, die beliebige Form haben kann, beispielsweise kreisförmig, rechteckig, quadratisch, vieleckig oder ähnlich. Die Ausnehmung 31 ist beispielsweise zentrisch bezüglich der Aktorachse 32 angeordnet.

Beispielsweise sind mehrere Dämpfungselemente 30 vorgesehen und übereinander zu einem Stapel geschichtet. Beispielsweise sind zwei bis zehn Dämpfungselemente 30 übereinander angeordnet. Die mehreren Dämpfungselemente 30 sind beispielsweise an Nahtstellen miteinander verklebt oder verschweisst. Ein solcher Stapel aus Dämpfungselementen 30 kann auch durch mäanderförmiges Falten eines einzigen großen Dämpfungselementes 30 gebildet sein.

An seinen Rändern ist das Dämpfungselement 30 beispielsweise durch Kleben oder Schweißen gesäumt, so dass der Faserwerkstoff nicht wieder in Einzelfasern zerfällt. Die Krafteinleitung bzw. der Kraftdurchfluß erfolgt nicht an den Nahtstellen, da dort die schalldämpfende Wirkung verringert ist.

Das Dämpfungselement 30 gemäß dem ersten Ausführungsbeispiel weist sehr viele Kontaktstellen zwischen den Fasern auf, an denen Schallbrechung erfolgt. Das Dämpfungselement 30 absorbiert den Schall zumindest teilweise, indem es die Schwingungsenergie der Schallwellen beispielsweise in Wärme umwandelt.

Das zumindest eine Dämpfungselement 30 wird in der Aktorhülse 24 derart auf Druck vorgespannt, dass es sich im eingebauten Zustand starr und unelastisch verhält. Auf diese Weise ist gewährleistet, dass der Hub des Aktors 3.1 zumindest nahezu vollständig auf den hydraulischen Koppler 9 bzw. auf die Ventilnadel 4 übertragen wird und kein Hubverlust in der Aktorhülse 24 auftritt.

Das Dämpfungselement 30 gemäß dem ersten Ausführungsbeispiel bewirkt außerdem eine Verringerung der von dem Aktor ausgehenden elektromagnetischen Störungen, da die Dielektrizitätskonstante des zumindest einen Dämpfungselements 30 kleiner ist als die der keramischen Schichten des Aktors 3.1, so dass sich eine kleinere Störkapazität ergibt als ohne das zumindest eine Dämpfungselement 30.

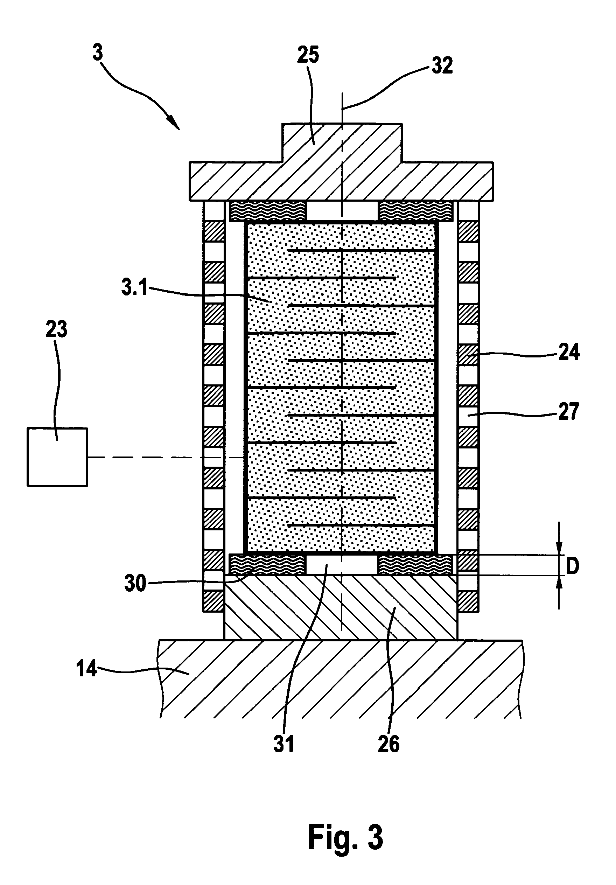

Fig. 3 zeigt ein erfindungsgemäßes Aktormodul gemäß einem zweiten Ausführungsbeispiel.

Bei dem Aktormodul nach Fig.3 sind die gegenüber dem Brennstoffeinspritzventil nach Fig.1 und dem Aktormodul nach Fig.2 gleichbleibenden oder gleichwirkenden Teile durch die gleichen Bezugszeichen gekennzeichnet.

Das Aktormodul nach Fig.3 unterscheidet sich von dem Aktormodul nach Fig.2 darin, dass jeweils ein oder mehrere Dämpfungselemente 30 zwischen dem Aktorkopf 25 und dem Aktor 3.1 und zwischen dem Aktorfuß 26 und dem Aktor 3.1 angeordnet sind. Auf diese Weise werden die Störkapazitäten am effektivsten verringert.

Durch die erfindungsgemäße Ausführung des Aktormoduls gemäß dem ersten und dem zweiten Ausführungsbeispiel können aufwendige Entstörmaßnahmen am Steuergerät entfallen, beispielsweise eine Abschirmung der elektrischen Zuleitungen zum Aktor 3.1 oder des elektronischen Steuergerätes, oder sehr wirksam ergänzt werden, so daß die gleiche Entstörwirkung einfacher und kostengünstiger als beim Stand der Technik erreicht oder eine höhere Entstörwirkung bei gleich hohem Kostenaufwand wie beim Stand der Technik erzielt wird.

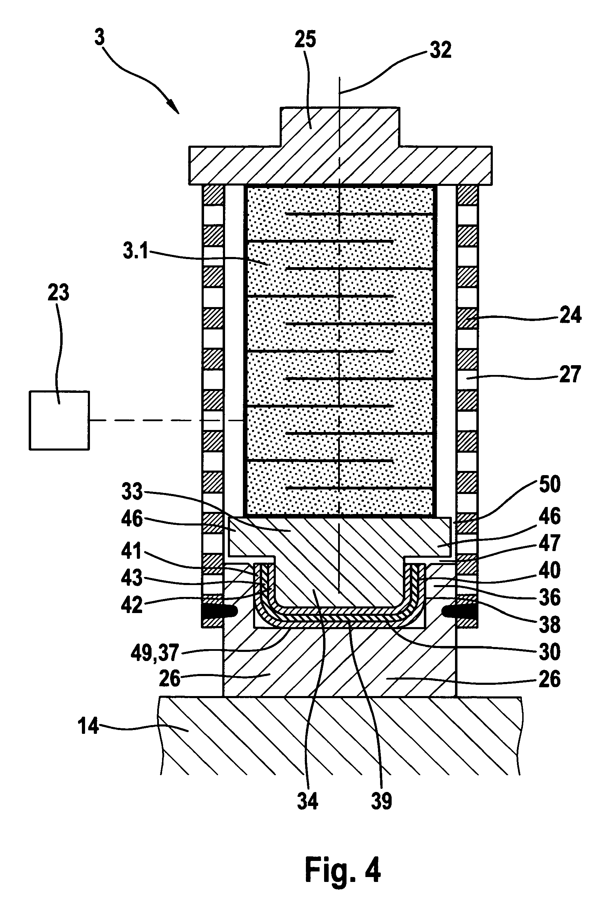

Fig. 4 zeigt ein erfindungsgemäßes Aktormodul gemäß einem dritten Ausführungsbeispiel.

Bei dem Aktormodul nach Fig.4 sind die gegenüber dem Brennstoffeinspritzventil nach Fig. und dem Aktormodul nach Fig.2 und Fig.3 gleichbleibenden oder gleichwirkenden Teile durch die gleichen Bezugszeichen gekennzeichnet.

Das Aktormodul nach Fig.4 unterscheidet sich von dem Aktormodul nach Fig.2 und Fig.3 darin, dass in der Aktorhülse 24 zusätzlich eine Aktorplatte 33 angeordnet ist. Die beispielsweise zylinderförmige Aktorplatte 33 ist an einer der Stirnseiten des Aktors 3 vorgesehen, beispielsweise zwischen dem Aktorfuß 26 und der dem Aktorfuß 26 zugewandten Stirnseite des Aktors 3.1. Die Aktorplatte 33 weist beispielsweise einen Zapfen 34 auf, der in eine Vertiefung 37 des Aktorkopfes 25 oder des Aktorfußes 26 hineinragt. Der Zapfen 34 ist beispielsweise zentrisch bezüglich der Aktorachse 32 angeordnet und weist eine kleinere radiale Erstreckung bezüglich der Aktorachse 32 auf als die Aktorplatte 33, so dass eine erste Schulter 46 gebildet ist. Durch die Vertiefung 37 entsteht ein der Aktorplatte 33 zugewandter und ein die Vertiefung 37 umgebender Ringbund 36. Zwischen der ersten Schulter 46 und dem Ringbund 36 des Aktorkopfes 25 bzw. des Aktorfußes 26 ist ein Axialspalt 47 vorgesehen.

Zwischen einer Wandung der Vertiefung 37 und dem Zapfen 34 der Aktorplatte 33 ist ein Spalt 38 gebildet, der beispielsweise topfförmig ist. In diesem Spalt 38 ist das Dämpfungselement 30 angeordnet. Das Dämpfungselement 30 gemäß dem dritten Ausführungsbeispiel ist der Form des Spaltes 38 angepasst und beispielsweise topfförmig ausgeführt mit einem ersten Boden 39 und einem Axialabschnitt 40. Das Dämpfungselement 30 ist in dem Spalt 38 zwischen dem Kopfteil 25 bzw. dem Fußteil 26 und der Aktorplatte 33 fest eingespannt, so dass der erste Boden 39 des Dämpfungselements 30 auf Druck belastet ist.

Das Dämpfungselement 30 ist beispielsweise aus einem dreischichtigen Werkstoffverbund bestehend aus einer ersten Deckschicht 41, einer zweiten Deckschicht 42 und einer zwischen der ersten Deckschicht 41 und der zweiten Deckschicht 42 angeordneten elastischen Dämpfungsschicht 43 hergestellt. Die beiden Deckschichten 41,42 sind beispielsweise aus Stahlblech und die elastische Dämpfungsschicht 43 beispielsweise aus einem Elastomer, Gummi oder anderen elastischen Stoffen gefertigt. Die erste Deckschicht 41 und die zweite Deckschicht 42 sind jeweils fest mit der elastischen Dämpfungsschicht 43 verbunden, beispielsweise mittels Kleben. Es ist auch möglich, dass das Dämpfungselement 30 keine Deckschichten 41,42 aufweist und nur durch die elastische Dämpfungsschicht 43 gebildet ist, die außer aus einem Elastomer, Gummi auch beispielsweise aus Grauguss hergestellt sein kann, da dieses auch gute Dämpfungseigenschaften hat. Desweiteren kann für das Dämpfungselement 30 nur eine erste Deckschicht 41 mit einer auf die erste Deckschicht 41 aufgebrachten elastischen Dämpfungsschicht 43 vorgesehen sein.

Bei der Betätigung des Aktors 3.1 wird der Hub des Aktors 3.1 über die Aktorplatte 33 und den ersten Boden 39 des Dämpfungselements 30 zumindest nahezu hubverlustfrei auf das Stellglied, beispielsweise die Ventilnadel 4, übertragen, da das Dämpfungselement 30 auf Druck vorgespannt ist und sich daher steif verhält. Die Hubübertragung erfolgt ausschließlich über den ersten Boden 39, da zwischen der ersten Schulter 46 und dem Ringbund 36 der Axialspalt 47 besteht. Nach jedem Hub des Aktors 3.1 schwingt der Aktor 3.1 nach, so dass das Dämpfungselement 30 im Axialabschnitt 40 auf Scherung beansprucht wird. Dabei wird jeweils die erste Deckschicht 41 relativ zur zweiten Deckschicht 42 verschoben, so dass die den Deckschichten 41,42 zugewandten Randschichten der elastischen Dämpfungsschicht 43 relativ zueinander verschoben werden und die elastische Dämpfungsschicht 43 eine Scherverformung erfährt. Durch die innere Reibung in der elastischen Dämpfungsschicht 43 wird die mechanische Schwingungsenergie in Wärme umgewandelt und auf diese Weise eine wirkungsvolle Schalldämpfung bewirkt. Die Deckschichten 41,42 schützen die elastische Dämpfungsschicht 43 vor Verschleiß, Beschädigung und Versprödung.

Zwischen der Aktorhülse 24 und der zusätzlichen Aktorplatte 33 besteht ein kleiner Radialspalt 50.

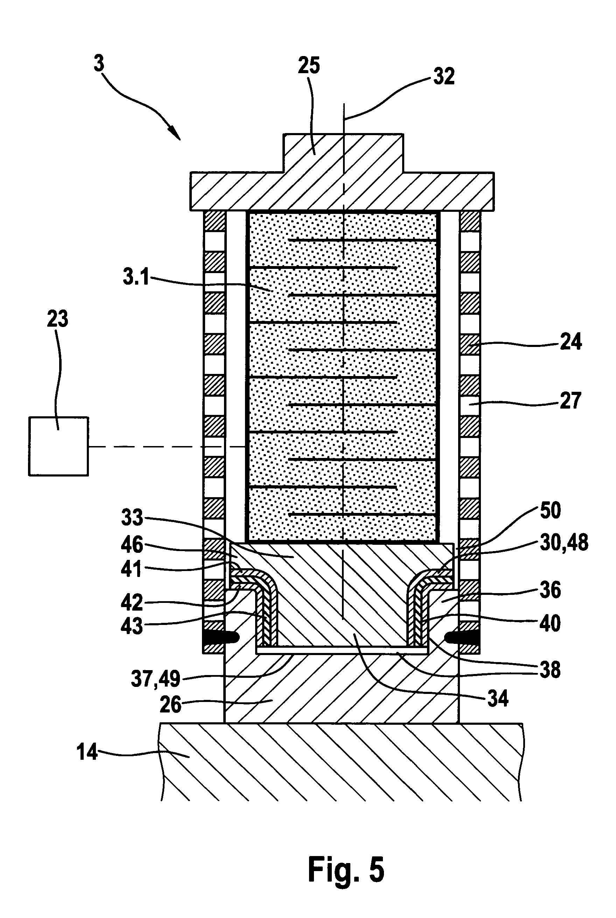

Fig. 5 zeigt ein erfindungsgemäßes Aktormodul gemäß einem vierten Ausführungsbeispiel.

Bei dem Aktormodul nach Fig.5 sind die gegenüber dem Brennstoffeinspritzventil nach Fig.1 und dem Aktormodul nach Fig.2 bis Fig.4 gleichbleibenden oder gleichwirkenden Teile durch die gleichen Bezugszeichen gekennzeichnet.

Das Aktormodul nach Fig.5 unterscheidet sich von dem Aktormodul nach Fig.4 darin, dass das Dämpfungselement 30 nicht topfförmig, sondern hülsenförmig ausgebildet ist. Der Boden des Dämpfungselements 30 gemäß dem dritten Ausführungsbeispiel entfällt. Stattdessen weist das Dämpfungselement 30 an einem der ersten Schulter 46 der Aktorplatte 33 zugewandten Ende eine zweite Schulter 48 auf, die von dem Axialabschnitt 40 ausgehend bis in den Axialspalt 47 reicht und diesen ausfüllt. Zwischen der dem Aktorkopf 25 bzw. dem Aktorfuß 26 zugewandten Stirnseite des Zapfens 34 und einem zweiten Boden 49 der Vertiefung 37 ist kein Dämpfungselement 30 vorgesehen, so dass der Spalt 38 in diesem Bereich nicht ausgefiillt ist.

Bei der Betätigung des Aktors 3.1 wird der Hub des Aktors 3.1 über die Aktorplatte 33 und die zweite Schulter 48 des Dämpfungselements 30 zumindest nahezu hubverlustfrei auf ein Stellglied, beispielsweise die Ventilnadel 4, übertragen, da das Dämpfungselement 30 auf Druck vorgespannt ist und sich daher steif verhält. Die Hubübertragung erfolgt ausschließlich über die zweite Schulter 48 des Dämpfungselementes 30, da der Spalt 38 zwischen der Stirnseite des Zapfens 34 und dem zweiten Boden 49 der Vertiefung 37 nicht ausgefüllt ist und in diesem Bereich ein Spiel vorgesehen ist.

Nach jedem Hub des Aktors 3.1 schwingt der Aktor 3.1 nach, so dass das Dämpfungselement 30 im Axialabschnitt 40 auf Scherung beansprucht wird. Dabei wird jeweils die erste Deckschicht 41 relativ zur zweiten Deckschicht 42 verschoben, so dass die den Deckschichten 41,42 zugewandten Randschichten der elastischen Dämpfungsschicht 43 relativ zueinander verschoben werden und die elastische Dämpfungsschicht 43 eine Scherverformung erfährt.

Gemäß dem dritten und vierten Ausführungsbeispiel nach Fig.4 und Fig.5 ist auch möglich, das Dämpfungselement 30 und die Aktorplatte 33 ausserhalb der Aktorhülse 24 in einer Vertiefung anzuordnen, mit dem Nachteil, dass die Schalldämpfung weiter entfernt von der Schallquelle erfolgt und daher geringer ist als bei der Anordnung des Dämpfungselements 30 und der Aktorplatte 33 in der Aktorhülse 24.

## Patentansprüche

1. Aktormodul mit einem piezoelektrischen, magnetostriktivem oder Formgedächtnis-Aktor und einer den Aktor umgebenden Aktorhülse, die von der einen Stirnseite von einem Aktorkopf und von der anderen Stirnseite von einem Aktorfuß verschlossen ist, und mit zumindest einem dem Aktormodul zugeordneten, in der Aktorhülse (24) angeordneten Dämpfungselement zur Dämpfung der vom Aktor ausgehenden Schallwellen, **dadurch gekennzeichnet, dass** das Dämpfungselement (30) zwischen dem Aktorkopf (25) und dem Aktor (3) und/oder zwischen dem Aktorfuß (26) und dem Aktor (3) angeordnet ist.

2. Aktormodul nach Anspruch 1, **dadurch gekennzeichnet, dass** das Dämpfungselement (30) aus Faserwerkstoff hergestellt ist.

3. Aktormodul nach Anspruch 2, **dadurch gekennzeichnet, dass** als Faserwerkstoff Aramidfaser, Kohlefaser oder Glasfaser vorgesehen ist.

4. Aktormodul nach Anspruch 2, **dadurch gekennzeichnet, dass** das zumindest eine Dämpfungselement (30) scheibenförmig oder lochscheibenförmig ausgebildet ist

5. Aktormodul nach Anspruch 1, **dadurch gekennzeichnet, dass** in der Aktorhülse (24) eine zusätzliche Aktorplatte (33) vorgesehen ist, die mit einem Zapfen (34) in eine an dem Aktorkopf (25) oder an dem Aktorfuß (26) ausgebildete Vertiefung (37) hineinragt, wobei das Dämpfungselement (30) in einem Spalt (38) zwischen dem Zapfen (34) und einer Wandung der Vertiefung (37) angeordnet ist.

6. Aktormodul nach Anspruch 5, **dadurch gekennzeichnet, dass** das Dämpfungselement (30) topfförmig mit einem Axialabschnitt (40) und einem Topfboden (39) ausgeführt ist.

7. Aktormodul nach Anspruch 5, **dadurch gekennzeichnet, dass** das Dämpfungselement (30) hülsenförmig mit einem Axialabschnitt (40) und einer zweiten Schulter (48) ausgebildet ist.

8. Aktormodul nach Anspruch 1, **dadurch gekennzeichnet, dass** das Dämpfungselement (30) eine elastische Dämpfungsschicht (43) aufweist.

9. Aktormodul nach Anspruch 8, **dadurch gekennzeichnet, dass** die elastische Dämpfungsschicht (43) zwischen zwei Deckschichten (41,42) des Dämpfungselements (30) angeordnet ist.

## Claims

1. Actuator module with a piezoelectric, magnetostrictive or form-memory actuator and with an actuator sleeve which surrounds the actuator and which is closed from one end face by an actuator head and from the other end face by an actuator foot, and with at least one damping element, assigned to the actuator module and arranged in the actuator sleeve (24), for damping the sound waves emanating from the actuator, **characterized in that** the damping element (30) is arranged between the actuator head (25) and the actuator (3) and/or between the actuator foot (26) and the actuator (3).

2. Actuator module according to Claim 1, **characterized in that** the damping element (30) is produced from fibre material.

3. Actuator module according to Claim 2, **characterized in that** aramide fibre, carbon fibre or glass fibre is provided as fibre material.

4. Actuator module according to Claim 2, **characterized in that** the at least one damping element (30) is designed in the form of a disc or in the form of a perforated disc.

5. Actuator module according to Claim 1, **characterized in that** an additional actuator plate (33) is provided in the actuator sleeve (24) and projects with a tenon (34) into a depression (37) formed on the actuator head (25) or on the actuator foot (26), the damping element (30) being arranged in a gap (38) between the tenon (34) and a wall of the depression (37).

6. Actuator module according to Claim 5, **characterized in that** the damping element (30) is of pot-shaped design with an axial portion (40) and with a pot bottom (39).

7. Actuator module according to Claim 5, **characterized in that** the damping element (30) is of sleeve-shaped design with an axial portion (40) and with a second shoulder (48).

8. Actuator module according to Claim 1, **characterized in that** the damping element (30) has an elastic damping layer (43).

9. Actuator module according to Claim 8, **characterized in that** the elastic damping layer (43) is arranged between two covering layers (41, 42) of the damping element (30).

## Revendications

1. Module d'actionneur comportant un actionneur piézo-électrique, magnétostrictif ou à mémoire de forme ainsi qu'une enveloppe d'actionneur entourant l'actionneur, cette enveloppe ayant une face frontale fermée par une tête d'actionneur et l'autre face frontale par un pied d'actionneur, et au moins un élément amortisseur associé au module d'actionneur, installé dans le manchon d'actionneur (24) pour amortir les ondes sonores émises par l'actionneur,
**caractérisé en ce que**
l'élément d'amortissement (30) est installé entre la tête d'actionneur (25) et l'actionneur (3) et/ou entre le pied d'actionneur (26) et l'actionneur (3).

2. Module d'actionneur selon la revendication 1,
**caractérisé en ce que**
l'élément d'amortissement (30) est réalisé en une matière fibreuse.

3. Module d'actionneur selon la revendication 2,
**caractérisé en ce que**
la matière fibreuse est de la fibre d'aramide, de la fibre de carbone ou de la fibre de verre.

4. Module d'actionneur selon la revendication 2,
**caractérisé en ce qu'**
au moins un élément amortisseur (30) est en forme de disque ou de disque à trou.

5. Module d'actionneur selon la revendication 1,
**caractérisé par**
une plaque d'actionneur supplémentaire (33) dans le manchon d'actionneur (24), cette plaque pénétrant avec un goujon (34) dans une cavité (37) réalisée dans la tête d'actionneur (25) ou dans le pied d'actionneur (26),
l'élément amortisseur (30) étant placé dans l'intervalle (38) entre le goujon (34) et la paroi de la cavité (37).

6. Module d'actionneur selon la revendication 5,
**caractérisé en ce que**
l'élément amortisseur (30) a une forme de pot avec un segment axial (40) et un fond de pot (39).

7. Module d'actionneur selon la revendication 5,
**caractérisé en ce que**
l'élément amortisseur (30) est en forme de manchon comprenant un segment axial (40) et un second épaulement (48).

8. Module d'actionneur selon la revendication 1,
**caractérisé en ce que**
l'élément amortisseur (30) comporte une couche élastique d'amortissement (43).

9. Module d'actionneur selon la revendication 8,
**caractérisé en ce que**
la couche d'amortissement (43) est prévue entre deux couches de recouvrement (41, 42) de l'élément amortisseur (30).
